Europäisches Patentamt

European Patent Office

Office européen des brevets

(11) Veröffentlichungsnummer: **0 059 381**
A2

(12) # EUROPÄISCHE PATENTANMELDUNG

(21) Anmeldenummer: 82101242.4

(22) Anmeldetag: 18.02.82

(51) Int. Cl.³: **H 05 K 7/02**
H 01 R 13/514

(30) Priorität: 26.02.81 DE 3107257

(43) Veröffentlichungstag der Anmeldung:
08.09.82 Patentblatt 82/36

(84) Benannte Vertragsstaaten:
AT BE CH DE FR GB IT LI LU NL SE

(71) Anmelder: Schneider Elektronik GmbH & Co.
Rundfunkwerk KG
Römerstrasse 36
D-7911 Strass/Nersingen(DE)

(72) Erfinder: Elster, Günther
Geisloherweg 6
D-8870 Günzburg(DE)

(74) Vertreter: Müller-Boré, Deufel, Schön, Hertel
Patentanwälte
Postfach 86 07 20 Siebertstrasse 4
D-8000 München 86(DE)

(54) Baustein oder Gerät für eine aus wenigstens zwei Bausteinen bestehende Audio- oder Hi-Fi-Anlage.

(57) Die Erfindung betrifft einen Baustein 1 für eine Hi-Fi-Anlage. Dieser Baustein weist Steckverbindungskontakte $P_1$ bis $P_4$ auf, wobei der Steckverbindungskontakt $P_1$ an der Oberseite 10, der Steckverbindungskontakt $P_2$ an der rechten Seite 11, der Steckverbindungskontakt $P_3$ an der Unterseite 12 und der Steckverbindungskontakt $P_4$ an der linken Seite 13 angeordnet ist. Diese Steckverbindungskontakte sind im Inneren miteinander und zumindest mit der NF-Signalquelle des Bausteins verbunden. Eine Verkabelung ist nicht mehr erforderlich, da die einzelnen Bausteine miteinander über die Steckverbindungskontakte sowohl bei einer Anordnung nebeneinander als auch übereinander verbunden werden können.

EP 0 059 381 A2

- 1 -

## Baustein oder Gerät für eine aus wenigstens zwei Bausteinen bestehende Audio- oder Hi-Fi-Anlage

Die Erfindung betrifft einen Baustein oder ein Gerät wie Tuner, Cassettenrecorder, Plattenspieler, Vorverstärker od. dgl., für eine aus wenigstens zwei Bausteinen bestehende Audio- oder Hi-Fi-Anlage, deren Bausteine durch mehr- oder n-polige-Funktionsverbindungsleitungen miteinander verbunden sind.

Bausteine oder Geräte, wie Tuner, Cassettenrecorder, Plattenspieler, Vorverstärker od. dgl. für Hi-Fi- oder Stereoanlagen erfordern eine aufwendige und umfangreiche Verkabelung.

Aufgabe der Erfindung ist es, die beim Zusammensetzen bzw. Zusammenstellen von Komponenten oder Bausteinen oder Geräten derartiger Anlagen erforderliche Verkabelung zu vereinfachen.

Erfindungsgemäß wird diese Aufgabe bei einem Baustein oder einem Gerät der oben genannten Gattung dadurch gelöst, daß der Baustein in der Oberseite, der Unterseite und in wenigstens den zwei gegenüberliegenden, rechtwinklig zur Frontplatte verlaufenden Seitenflächen je einen mehr- oder n-poligen Steckverbindungskontakt aufweist und daß die Steckverbindungskontakte miteinander und zumindest mit der NF-Signalquelle und/oder dem NF-Signaleingang des Bausteins verbunden sind. Besonders vorteilhaft ist dabei der Baustein ein Parallelepiped, während die Steckverbindungskontakte am Baustein auf den rechtwinklig zueinander stehenden Achsen eines Koordinatensystems angeordnet sind. Wesentlich ist, daß der Pegel der Ausgangs- und Eingangssignale aller Bausteine gleich ist. Insbesondere bedarf es hierzu eines eigenen Vorverstärkers im Plattenspieler, der das Ausgangssignal des Abnehmersystems auf den gemeinsamen Pegel anhebt.

Durch diese Ausbildung können die Bausteine in beliebiger Weise aufeinander gesetzt oder nebeneinander angeordnet werden, und die Funktionsverbindung zwischen den Bauteilen erfolgt durch eine einfache Steckverbindung, die beim Zusammensetzen der Bauteile zu einer Anlage zustandekommt. Im zusammengesetzten Zustand verlaufen dann praktisch die Funktionsverbindungsleitungen durch die gesamte Anlage hindurch.

Besonders vorteilhaft ist hierbei die Anordnung, daß die Steckverbindungskontakte am Baustein auf den rechtwinklig zueinander stehenden Achsen eines Koordinatensystems angeordnet sind. Man kann dadurch die Bauteile zu einem Turm zusammensetzen und man kann nebeneinander anordnen, also in einer Reihe oder je nach den Gegebenheiten L-förmige oder T-förmige oder Z-förmige Anlagen bilden, wobei die Bausteine in beliebiger Reihenfolge kombiniert werden können. Auch ist der Umbau oder die Umstellung der Bausteine einer bereits vorhandenen Anlage in einfachster Weise möglich, da lediglich Steckverbindungen gelöst und wieder hergestellt werden müssen und keinesfalls komplizierte und umfangreiche Verkabelung durchgeführt werden muß.

Besonders vorteilhaft ist es, wenn zwischen der NF-Signalquelle des Bausteins und den Steckverbindungskontakten ein Operationsverstärker oder Diskreter Verstärker plus Impedanzwandler eingeschaltet ist. Um Brummeinstreuungen sowie Störeinstrahlungen zu unterbinden, werden die NF-Signalpegel sehr niederohmig geschaltet. Ferner wird die Ausgangsspannung höher gelegt, und dies geschieht durch die Verwendung des zusätzlichen Operationsverstärkers oder Diskreter Verstärker plus Impedanzwandler hinter jeder NF-Signalquelle.

Mit besonderem Vorteil ist zwischen der NF-Signalquelle eines jeden Bausteins und dem Steckverbindungskontakt ein Signalquellenumschalter geschaltet. Hierdurch kann man beispielsweise, wenn man einen Tuner, einen Cassettenrecorder, einen Plattenspieler und einen Vorverstärker verwendet, bei einem Rundfunkempfänger die NF-Signalquellen des Cassettenrecorders und des Plattenspielers abschalten, so daß lediglich die NF-Signalquelle des Tuners mit dem Vorverstärker verbunden ist. Wenn man Tuner und Cassettenrecorder ausschaltet, dann kann lediglich das NF-Signal des Plattenspielers zum Vorverstärker gelangen, ohne daß zusätzliche Verbindungsleitungen erforderlich sind. Hierbei kann es vorteilhaft sein, daß an die NF-Signalquelle des Bausteins der Operationsverstärker oder Diskreter Verstärker plus Impedanzwandler angeschlossen ist und daß der Signalquellenumschalter diesem nachgeschaltet ist.

Wenn der Baustein als Vorverstärker ausgebildet ist, wird dessen NF-Signaleingang direkt mit den mehr- oder n-poligen Steckverindungskontakten verbunden, wobei dessen Ausgang dann einen weiteren Steckverbindungskontakt zur Verbindung mit dem Endverstärker aufweist.

Einer der Bausteine kann mit Vorteil einen zusätzlichen NF-Signaleingang aufweisen, der über einen Operationsverstärker und/oder Diskreter Verstärker plus Impedanzwandler und NF-Signalquellenumschalter mit den Steckverbindungskontakten verbunden ist. Hierdurch ist es möglich, weitere NF-Signalquellen, wie beispielsweise Mikrofone, Tonbandgeräte, Plattenspieler u.dgl., an die Anlage anzuschließen.

Besonders vorteilhaft ist es, wenn der Baustein einen zusätzlichen NF-Signaleingang aufweist, der Vorverstärker ist.

Zweckmäßigerweise sind die NF-Signalquellenumschalter selbstrastende Umschalttasten. Wenn man also beispielsweise einen der Bausteine, wie den Tuner, in Betrieb nehmen will, wird die entsprechende Umschalttaste betätigt, und dadurch werden die anderen Umschalttasten ausgeschaltet, so daß dann lediglich der Tuner mit dem Vorverstärker verbunden ist.

Besonders vorteilhaft ist es, wenn die NF-Signalquellenumschalter sich gegenseitig elektrisch auslösen und Tipp- oder Sensortasten sind. Die Signalumschaltung kann aber auch elektronisch über einen Flip-Flop mit nachgeschaltetem elektronischem NF-Schalter oder Kleinrelais erfolgen.

In vorteilhafter Weise wird durch die Signalumschaltung direkt am Baustein die Anzahl der Durchgänge in der Steckverbindung reduziert, und es wird dadurch auf eine Quellenumschaltung am NF-Vorverstärker bzw. Endverstärker verzichtet. Für die NF-Wiedergabeinformation sind demzufolge in der gesamten Steckverbindung nur zwei Pole für den linken und rechten Kanal erforderlich, wenn Vorverstärker und Endstufe ein Baustein ist. Wenn Vorverstärker und Endverstärker getrennte Bausteine darstellen, sind zwei weitere Pole sowohl für den linken als auch den rechten Kanal erforderlich, wenn eine freie Austauschbarkeit der Bausteine untereinander beibehalten werden soll.

Mit besonderem Vorteil können dabei die NF-Signalumschalter mit einem Reset-Leitungspol der mehr- oder n-poligen Steckverbindungskontakte verbunden sein.

Ferner kann es von Vorteil sein, daß die Steckverbindungskontakte und deren Verbindungsleitungen Pole bzw. Leitungsteile für eine Speisespannung aufweisen, die den Verbrauchern im Baustein zugeführt wird. Hierdurch ist für das gesamte System lediglich eine einzige bzw. zwei Steckkontaktverbindungen erforderlich. Die Spannung kann beispielsweise über den Endverstärker zugeführt werden. Es kann aber auch ein getrennter Versorgungsbaustein vorgesehen sein, der mit dem Gesamtsystem ebenfalls über die Steckkontaktverbindung verbunden wird.

Die Steckverbindungskontakte und deren Verbindung zur Leitung können ferner Pole bzw. Leitungsteile für weitere Funktionen, wie Fernbedienung, Timer usw., aufweisen. Durch diesen Aufbau ist lediglich ein zentraler Schalter erforderlich, sowie ein einziger Netzstecker.

Wenn man davon ausgeht, daß, wenn Tonbandaufnahmen gemacht werden, niemals gleichzeitig vom gleichen Gerät wiedergegeben wird, kann ein besonders einfacher Aufbau dadurch erzielt werden, daß der NF-Signalumschalter des Cassettenrecorders bei Abschaltung dieses Bausteins auf einen Aufnahmeverstärker für eine Tonbandaufnahme umschaltbar ist. Wenn man also den Tuner einschaltet, wird der Plattenspieler ausgeschaltet, und der Cassettenrecorder schaltet auf den Aufnahmeverstärker um, d.h. die durch diesen Recorder hindurchgehende NF-Signalleitung wird auf Aufnahme geschaltet. Wenn man also vom Tuner aufnehmen will, muß man nur noch das Laufwerk des Cassettenrecorders einschalten. Wenn man nicht aufnehmen will, wird dieses Laufwerk ausgeschaltet, wobei das vom Tuner abgegebene NF-Signal lediglich vom Vorverstärker weiterverarbeitet wird. Bei nicht betätigter Play-Taste des Cassettenrecorders befindet sich also der NF-Signalschalter automatisch in der Aufnahmestellung. Ähnliches gilt, wenn man vom Plattenspieler auf den Cassettenrecorder überspielen will, dann wird lediglich der Signalumschalter des Plattenspielers betätigt, wodurch der Tuner ausgeschaltet wird, und der Cassettenrecorder befindet sich in der Aufnahmestellung, so daß aufgenommen werden kann, wobei die Möglichkeit besteht, daß die dem Aufnahmeverstärker zugeführten Signale gleichzeitig über den Vorverstärker abgehört werden können. Eine Hinterbandkontrolle ist dabei grundsätzlich möglich. Soll hierbei die Wiedergabe über die Gerätelautsprecher erfolgen, sind im Stecksystem zwei zusätzliche Pole bereitzustellen. Ohne Zusatzkontakte ist eine Hinterbandkontrolle nur über Kopfhörer am Cassettengerät selbst möglich.

Mit besonderem Vorteil weisen die mehr- oder n-poligen Steckverbindungskontakte konische Stecker und konische Buchsen auf, so daß eine gute Kontaktverbindung hergestellt wird. Beispielsweise können auf den Oberseiten
Buchsen und auf den Unterseiten Stecker vorgesehen sein,
wobei auf den Seiten jeweils eine Buchse und ein Stecker
in symmetrischer Anordnung vorgesehen ist, so daß ein
leichtes Zusammenbauen ermöglicht wird.

Der Stecker, der an der Ober- oder Unterseite angeordnet
ist, kann in vorteilhafter Weise ein Doppelkonus sein
und die zugeordnete auf der Unter- oder Oberseite liegende Buchse kann eine Doppelbuchse sein. Hierbei wird
eine einfache Montage dadurch ermöglicht, daß diese im
Baustein in einfacher Weise zusammengesteckt werden und
somit eine durchgehende Leitung bilden. Eine weitere
konstruktive Vereinfachung kann dadurch erfolgen, daß
an der Doppelbuchse eine Buchse oder ein Stecker für
eine Seitenwand ausgebildet ist.

Es ist darauf zu achten, daß auf den durch die Steckverbindungen miteinander verbindbaren Signalleitungen
die Signale von den Bausteinen mit gleichem Pegel bereitgestellt werden bzw. die Eingänge der einzelnen Bausteine auf diesen gemeinsamen Pegel ausgelegt sind.

Ausführungsbeispiele der Erfindung sollen in der folgenden Beschreibung unter Bezugnahme auf die Figuren der
Zeichnung erläutert werden. Es zeigen

Fig. 1 eine schematische Ansicht des erfindungsgemäßen Stecksystems für eine Audio- oder
        Hi-Fi- oder Stereo-Anlage,

Fig. 2 eine Schnittansicht eines Bausteins, bei der
        die elektronischen Bauteile dieses Bausteins
        nicht gezeigt sind sondern lediglich das

- 8 -

Steckverbindungssystem veranschaulicht ist und

Fig. 3 eine schematische Ansicht, welche die Anordnungsmöglichkeiten der Bausteine veranschaulicht.

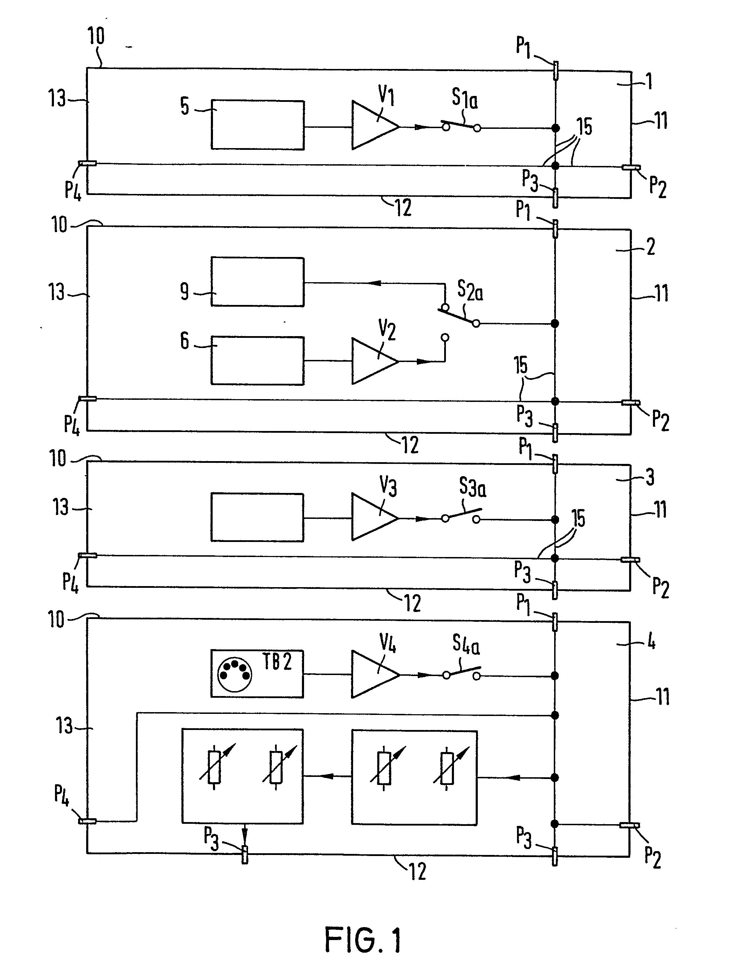

In Fig. 1 sind die Bausteine einer Hi-Fi-Anlage schematisch übereinander dargestellt. Bei dieser dargestellten Anordnung liegt der Tuner 1 über dem Cassettenrecorder 2 und darunter liegt der Plattenspieler 3 und an diesen schließt sich nach unten der Vorverstärker 4 an. Ein Endverstärker und Lautsprecher sind nicht dargestellt. Jeder der Bausteine 1 bis 4 dieses Systems weist vier Steckverbindungskontakte $P_1$, $P_2$, $P_3$, $P_4$ auf. Der Steckverbindungskontakt $P_1$ befindet sich jeweils auf der Oberseite des Bausteins, der Steckverbindungskontakt $P_2$ auf der rechten Seite des Bausteins, der Steckverbindungskontakt $P_3$ auf der Unterseite und der Steckverbindungskontakt $P_4$ auf der linken Seite. Diese Steckverbindungskontakte sind mehr- oder n-polige Kontakte, wobei die Anzahl der Pole durch die Anzahl der Funktionsleitungen bestimmt wird. Zumindest weist jeder Steckkontakt Pole für NF-Signale des linken und des rechten Kanals auf. Diese Steckverbindungskontakte sind über Leitungen 15 im Inneren eines jeden Bausteins miteinander verbunden.

Wenn, wie in Fig. 1 dargestellt, Bausteine 1 bis 4 in der dargestellten Lage zusammengesteckt werden, so ist zu erkennen, daß durch diese Steckverbindung eine vom Tuner 1 ausgehende, sich durch den Cassettenrecorder 2 und den Plattenspieler 3 hindurcherstreckende und zum Vorverstärker 4 führende durchgehende Signalleitung hergestellt wird. Ferner ist es durch die seitlichen Steckverbindungskontakte $P_2$ und $P_4$ möglich, die Geräte

auch nebeneinander anzuordnen. Die schematisch dargestellte Steckverbindung ermöglicht es außerdem, die Bausteine 1 bis 3 beliebiger Anordnung übereinander oder nebeneinander zusammenzusetzen.

Die Steckverbindungskontakte $P_1$ bis $P_4$ sind mit der NF-Signalquelle des Bausteins verbunden. Beim Baustein 1 handelt es sich hierbei um den AM/FM-Tuner 5, beim Cassettenrecorder 2 handelt es sich um den Wiedergabeverstärker 6 und beim Plattenspieler 3 handelt es sich um den Entzerrer-Vorverstärker 7. Beim Vorverstärker 4 sind die Steckverbindungskontakte $P_1$ bis $P_4$ direkt mit dem NF-Signaleingang 8 verbunden, und zwar handelt es sich hierbei um ein Element, in dem die Lautstärke und die Balance geregelt wird. Daran schließt sich ein Klangregelteil an. Dieser Klangregelteil seinerseits ist mit einem weiteren Steckverbindungskontakt $P_5$ verbunden, der an der Unterseite des Vorverstärkers vorgesehen ist, und es handelt sich hierbei um einen Signalausgang zum Endverstärker.

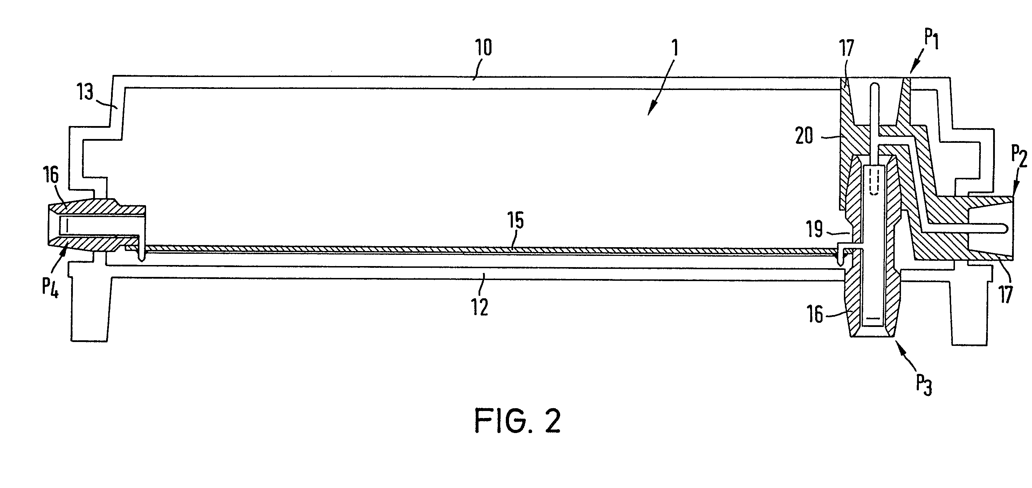

Wie insbesondere die Fig. 2 erkennen läßt, liegen die Steckverbindungskontakte $P_1$ bis $P_4$ der Bausteine 1 bis 4 auf den rechtwinklig zueinander stehenden Achsen eines Koordinatensystems.

Um eine Brummeinstreuungs- sowie Störeinstrahlungen zu unterbinden, sind die NF-Signalpegel sehr niederohmig geschaltet. Die Ausgangsspannung ist höher gelegt, und dies geschieht dadurch, daß zwischen den Steckverbindungskontakten $P_1$ bis $P_4$ und deren Verbindungsleitungen 15 den NF-Signalausgängen 5 bis 7 der Bausteine 1 bis 4 ein zusätzlicher Operationsverstärker oder Diskreter Verstärker plus Impedanzwandler geschaltet ist. Es handelt sich hierbei um die Verstärker $V_1$ bis $V_3$ bei den Bau-

steinen 1 bis 3. Diese Verstärker sind der NF-Signalquelle nachgeschaltet.

Wie in Fig. 1 dargestellt, kann einer der Bausteine beim
dargestellten Ausführungsbeispiel der Vorverstärker 4
einen zusätzlichen NF-Signaleingang 14 aufweisen, an
den zusätzliche Geräte, wie beispielsweise Mikrofone,
Bandgeräte, Plattenspieler u. dgl., angeschlossen werden
können. Dieser Signaleingang 14 ist über einen Verstärker
$V_4$ ebenfalls mit den zugehörigen Leitungen 15 und den
Steckverbindungskontakten $P_1$ bis $P_4$ verbunden.

Um die Anzahl der Durchgänge in der Steckverbindung
herabzusetzen, wird nicht, wie bisher, eine Quellenumschaltung am NF-Vorverstärker bzw. Endverstärker vorgenommen, sondern die Signalumschaltung erfolgt direkt
am einzelnen Signalbaustein und ist im Tuner 1 zwischen
NF-Signalquelle 5 und den Verbindungsleitungen 15 und
den Steckverbindungskontakten $P_1$ bis $P_4$ der Signalquellenumschalter S1a eingeschaltet. Beim Cassettenrecorder 2 ist ein Signalquellenumschalter S2a zwischen
dem Wiedergabeverstärker 6 und den entsprechenden Verbindungsleitungen 15 und den Steckverbindungskontakten
$P_1$ bis $P_4$ eingeschaltet. Beim Plattenspieler 3 ist der
Signalquellenumschalter S3a zwischen dem Entzerrer-
Vorverstärker 7 und den Leitungen 15 eingeschaltet und
beim Vorverstärker 4 der Signalquellenumschalter S4a
zwischen dem Eingang 14 und den Leitungen 15 eingeschaltet.

Diese Schalter S1a bis S4a können sich gegenseitig
elektrisch auslösende Tipptasten sein. Es können aber
auch konventionell rastende Tasten sein. Die NF-Umschaltung (Zuschaltung oder Abschaltung) erfolgt dann
entweder direkt über die selbstrastende mehrpolige Umschalttaste oder erfolgt elektronisch über ein Flip-Flop mit nachgeschaltetem elektronischem NF-Schalter oder Kleinrelais.

Wenn man beispielsweise nur Radio hören will, so wird der Signalquellenumschalter S1a betätigt. Dadurch fallen die anderen Umschalter S2a bis S4a ab und der Tuner ist über die Steckverbindungskontakte $P_1$ und $P_3$ durch den jeweiligen Oberseiten 10 und den jeweiligen Unterseiten 12 der Bausteine 1 bis 4 und die in den Geräten vorgesehenen Verbindungsleitungen 15 direkt mit dem Vorverstärker verbunden. Soll ein Betrieb des Plattenspielers 3 durchgeführt werden, so wird in entsprechender Weise der Schalter S3a betätigt und die anderen Schalter fallen ab, und das gleiche gilt auch für einen Betrieb über den Eingang 14, wobei der Schalter S4a betätigt wird. Wenn man den Schalter S2a des Cassettenrecorders 2 einschaltet, fallen, wie vorher dargelegt, die anderen Schalter ab, so daß lediglich ein Cassettenrecorderbetrieb durchgeführt werden kann.

Wenn man davon ausgeht, daß bei Tonbandaufnahmen niemals gleichzeitig vom gleichen Gerät wiedergegeben wird, so wird der Cassettenrecorder derart gestaltet, daß die Steckverbindungskontakte $P_1$ bis $P_4$ und der Verbindungsleitungen 15 auch mit dem Aufnahmeverstärker 9 des Cassettenrecorders über den gleichen Schalter S2a verbunden werden können. Die Umschaltung am Cassettengerät erfolgt also durch die gleiche Taste, wobei bei nicht eingeschaltetem Cassettenrecorder, d.h. bei nicht beabsichtigter Wiedergabe vom Cassettenrecorder, dieser automatisch auf Aufnahme geschaltet ist.

Wenn man also den Tuner oder den Plattenspieler oder den Eingang 14 in Betrieb nimmt, wird nicht nur eine Verbindungsleitung zum Vorverstärker 4 hergestellt sondern auch zum Aufnahmeverstärker 9 des Cassetten-recorders. Wenn man aufnehmen will, muß man nur noch das entsprechende Laufwerk betätigen. Dabei kann man gleichzeitig über den Vorverstärker die Signale hören, die dem Cassettenrecorder zugeführt werden.

Der Aufnahmeverstärker 9 kann dabei entsprechend ausgelegt sein.

Es ist möglich, die Stromversorgung der einzelnen Bausteine 1 bis 4 über das gleiche Stecksystem durchzuführen. Es kann eine gemeinsame niedervoltige Versorgungsspannung allen Gerätebausteinen über die Steckverbindungen zugeführt werden, wobei ein separater Versorgungsbaustein vorgesehen sein kann, oder es kann eine Versorgung aus dem Endverstärker heraus erfolgen, der ja über dem Steckverbindungskontakt $P_3$ auf der Unterseite 12 des Vorverstärkers 4 mit dem Stecksystem verbunden ist. Es sind hierfür nur zwei zusätzliche Pole erforderlich. Dies bringt den Vorteil mit sich, daß das gesamte Bausteinsystem, beispielsweise die Hi-Fi-Anlage, nur einen zentralen Ein- oder Ausschalter besitzt, sowie nur einen Netzstecker benötigt.

Verwendet man Flip-Flop-Schaltungen für die Tasten S1a bis S4a, so werden diese von Baustein zu Baustein über eine einzige Reset-Leitung miteinander verbunden.

Durch eine Erhöhung der Polzahl im Stecksystem ist es möglich, weitere Funktionen, wie z.B. Fernbedienung, Timer usw., im System unterzubringen.

Fig. 2 zeigt eine Schnittansicht des Bausteins 1, an dessen Oberseite 10 eine Buchse 17 angeordnet ist, die den Steckverbindungskontakt $P_1$ bildet. Auf der rechten Seite 11 des Bausteins 1 befindet sich eine Buchse 17, die den Steckverbindungskontakt $P_2$ bildet. Auf der Unterseite 12 des Bausteins 1 befindet sich ein Stecker 16, der den mehr- oder n-poligen Steckverbindungskontakt $P_3$ bildet, und auf der linken Seite 13 des Bausteins 1 befindet sich ein Stecker 16, der den n-poligen Steckverbindungskontakt $P_4$ bildet. Diese vier Steckverbindungskontakte sind mittels einer Leitung 15 miteinander verbunden. Um einen einfachen Aufbau zu ermöglichen, ist der Steckverbindungskontakt 16 ein Doppelkonus 19 und der Steckverbindungskontakt $P_1$ ist eine Doppelbuchse 20. Ein Ende des Doppelkonus 19 erstreckt sich nach außen, und das andere Ende ist im Inneren des Bausteins 1 mit einer Buchse der Doppelbuchse 20 verbunden, deren anderer Buchsenabschnitt 17 von außen zugänglich ist. Mit besonderem Vorteil kann an der Doppelbuchse 20 noch die Buchse 17 für die rechte Seite 11 des Bausteins 1 ausgebildet sein. Die Verbindung mit den elektronischen Teilen ist nicht dargestellt.

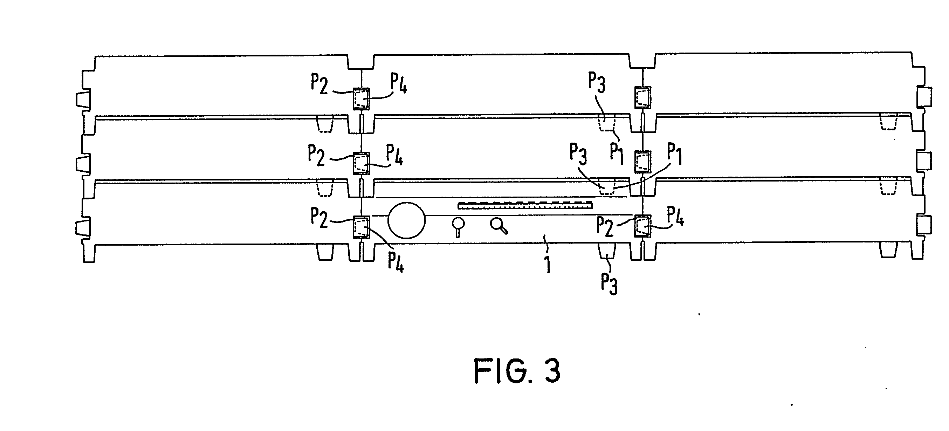

Fig. 3 zeigt die Bausteine im zusammengesetzten Zustand, wobei schematisch dargestellt ist, daß diese Bausteine sowohl übereinander als auch nebeneinander angeordnet werden können. Es kann auch eine T-förmige Anordnung der Bausteine durchgeführt werden, sowie eine L-förmige und eine Z-förmige.

## Patentansprüche

1. Baustein oder Gerät wie Tuner, Cassettenrecorder, Plattenspieler, Vorverstärker od. dgl., für eine aus wenigstens zwei Bausteinen bestehende Audio- oder Hi-Fi-Anlage , deren Bausteine durch mehr- oder n-polige Funktionsverbindungsleitungen miteinander verbunden sind, d a d u r c h g e k e n n z e i c h n e t, daß der Baustein (1-4) in der Oberseite (10), der Unterseite (12) und in wenigstens den zwei gegenüberliegenden, rechtwinklig zur Frontplatte verlaufenden Seitenflächen (11, 13) je einen mehr- oder n-poligen Steckverbindungskontakt ($P_1$ - $P_4$) aufweist und daß die Steckverbindungskontakte ($P_1$ - $P_4$) miteinander und zumindest mit der NF-Signalquelle (5, 7, 14) und/oder dem NF-Signaleingang (8, 9) des Bausteins verbunden sind.

2. Baustein nach Anspruch 1, d a d u r c h g e - k e n n z e i c h n e t, daß dieser ein Parallelepiped ist.

3. Baustein nach einem der Ansprüche 1 bis 4, d a - d u r c h g e k e n n z e i c h n e t, daß zwischen der NF-Signalquelle (5, 6, 7, 14) und den Steckverbindungskontakten ($P_1$ - $P_4$) ein Signalquellschalter (S1a - S4a) geschaltet ist.

4. Baustein nach einem der Ansprüche 1 bis 6, d a - d u r c h g e k e n n z e i c h n e t, daß die NF-Signalquellenpegel niederohmig geschaltet sind.

5. Baustein nach einem der Ansprüche 1 bis 8 , der ein Vorverstärker ist, d a d u r c h g e k e n n - z e i c h n e t, daß dessen NF-Signaleingang (8) direkt mit den mehr- oder n-poligen Steckverbindungskontakten ($P_1$ - $P_4$) verbunden ist und dessen Ausgang
einen weiteren Steckverbindungskontakt ($P_5$) aufweist.

6. Baustein nach einem der Ansprüche 5 bis 11, d a -
d u r c h   g e k e n n z e i c h n e t, daß die
NF-Signalumschalter (S1a - S4a) sich gegenseitig
elektrisch auslösende Tipp- oder Sensortasten sind
und die NF-Signalumschalter (S1a - S4a) mit einem
Reset-Leistungspol der mehr- oder n-poligen Steckverbindungskontakte ($P_1$ - $P_4$) verbunden sind.

7. Baustein nach einem der Ansprüche 1 bis 15, d a -
d u r c h   g e k e n n z e i c h n e t, daß die
Steckverbindungskontakte ($P_1$ - $P_4$) und deren Verbindungsleitungen (15) Pole bzw. Leitungsteile für
eine Speisespannung aufweisen, die den Verbrauchern
im Baustein zugeführt wird.

8. Baustein nach einem der Ansprüche 1 bis 17, der ein
Cassettenrecorder ist, d a d u r c h   g e k e n n -
z e i c h n e t, daß der Signalumschalter (S2a)
bei Abschaltung dieses Bausteins (2) auf einen Aufnahmeverstärker (9) für eine Tonbandaufnahme umschaltbar ist.

9. Baustein nach Anspruch 19, d a d u r c h   g e -
k e n n z e i c h n e t, daß der Stecker (16) an der
Ober- oder Unterseite ein Doppelkonus (19) und die
zugeordnete Buchse eine Doppelbuchse (20) ist und
daß diese im Baustein zusammengesteckt sind.

10. Baustein nach einem der vorhergehenden Ansprüche,
der ein Plattenspieler ist, d a d u r c h  g e -
k e n n z e i c h n e t, daß er einen eigenen Vorverstärker aufweist, der das Ausgangssignal des Abnehmersystems auf einen Pegel anhebt, der gleich dem
Pegel der übrigen Bausteine ist.

FIG.1

FIG. 2

0059381

FIG. 3